Europäisches Patentamt

European Patent Office

Office européen des brevets

(11) Veröffentlichungsnummer: **0 429 709 A1**

# (12) EUROPÄISCHE PATENTANMELDUNG

(21) Anmeldenummer: 89122102.0

(51) Int. Cl.⁵: **H01L 27/02**

(22) Anmeldetag: 30.11.89

(43) Veröffentlichungstag der Anmeldung:
05.06.91 Patentblatt 91/23

(84) Benannte Vertragsstaaten:
DE FR GB IT NL Patentblatt 00/2

(71) Anmelder: **Siemens Aktiengesellschaft**
**Wittelsbacherplatz 2**
**W-8000 München 2(DE)**

(72) Erfinder: **Becker, Burkhard, Dr. rer. nat.**
**Schlüsselbergstrasse 8**
**W-8000 München 80(DE)**

(54) **Eingangsschutzstruktur für integrierte Schaltungen.**

(57) Eine Eingangsschutzstruktur für integrierte Schaltungen mit einer Oxidisolation benachbarter Bauelemente ermöglicht durch einen Thyristor, einen integrierten Widerstand (5) und eine spezielle Anordnung und Struktur der den Thyristor bildenden Zonen in einem Halbleitersubstrat (10) eine hohe Belastbarkeit gegen elektrostatische Entladungen.

# FIG 2

## EINGANGSSCHUTZSTRUKTUR FÜR INTEGRIERTE SCHALTUNGEN

Die vorliegende Erfindung betrifft eine Eingangsschutzstruktur für integrierte Schaltungen nach dem Oberbegriff des Patentanspruchs 1.

Integrierte Schaltungen benötigen einen sicheren Schutz gegen elektrostatische Entladungen. Zu diesem Zweck werden sie mit Eingangsschutzstrukturen versehen, einige dem Stand der Technik entsprechende Strukturen sind in der DE-OS 36 16 394 erläutert. Eingangsschutzstrukturen für bipolare integrierte Schaltungen, die einen Thyristor und einen integrierten Widerstand enthalten, sind in DE-OS 32 01 933 und DE-OS 32 10 743 beschrieben. Jedoch beruhen in beiden Druckschriften die angegebenen Schutzstrukturen auf einer vorwiegend lateralen Arbeitsweise des Thyristors, so daß Oberflächendurchbrüche nicht vermieden werden können. Insbesondere sind sie nur bei bipolaren integrierten Schaltungen, bei denen benachbarte Bauelemente durch eine sogenannte PN-Isolation voneinander isoliert sind, vorteilhaft einsetzbar.

Der vorliegenden Erfindung liegt daher die Aufgabe zugrunde, eine Eingangsschutzstruktur für bipolare integrierte Schaltungen mit einer Isolation benachbarter Bauelemente durch Oxidgebiete anzugeben, die einen hohen Schutz gegen elektrostatische Entladungen aufweist.

Diese Aufgabe wird bei einer Eingangsschutzstruktur nach dem Oberbegriff des Patentanspruchs 1 erfindungsgemäß durch die Merkmale des kennzeichnenden Teils des Patentanspruchs 1 gelöst.

Weiterbildungen der Erfindung sind Gegenstand von Unteransprüchen.

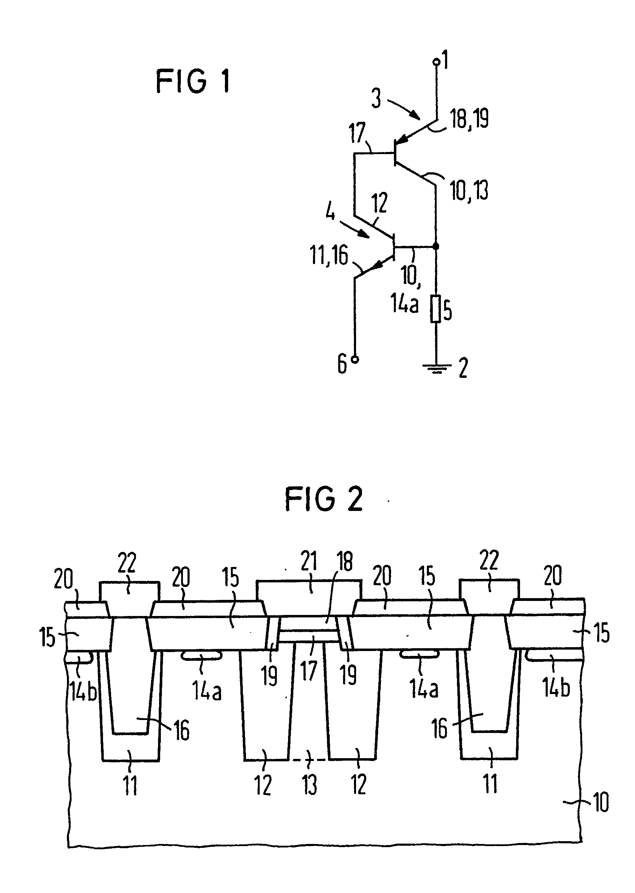

Die Erfindung wird im folgenden anhand eines Ausführungsbeispiels gemäß den Figuren 1 und 2 der Zeichnung näher erläutert. Es zeigt

FIG 1 ein Ersatzschaltbild einer Eingangsschutzstruktur in Form eines durch zwei Transistoren gebildeten Thyristors und eines integrierten Widerstandes gemäß der Erfindung, und

FIG 2 eine Ausführungsform der Realisierung einer Eingangsschutzstruktur nach Figur 1 in einem Halbleitersystem in schematischer Darstellung.

Gemäß Figur 1 liegt zwischen einem Eingangsanschluß 1 einer integrierten Schaltung, insbeondere einer bipolaren integrierten Schaltung, und einem Referenzpotential 2, insbesondere Masse, eine Schutzstruktur, die durch einen ersten Transistor 3 und einen zweiten Transistor 4, welche zu einem Thyristor gekoppelt sind, und einen Widerstand 5, der zwischen Basis 10 des zweiten Transistors 4 und das Referenzpotential 2 geschaltet ist, gebildet wird. Insbesondere ist dabei der Emitter 18, 19 des ersten Transistors 3 an den Eingang 1 und der Emitter 11, 16 des zweiten Transistors 4 an ein Versorgungspotential 6 angeschlossen. Der erste Transistor 3, bei dem es sich vorzugsweise um einen pnp-Transistor handelt, ist mit seiner Basis 17 an den Kollektor 12 des zweiten, vorzugsweise npn-Transistors 4 angeschlossen und mit seinem Kollektor 10, 13 an die Basis 10 des zweiten Transistors 4.

Die Bezugszeichen nach Figur 1 sind in Übereinstimmung mit den Bezugszeichen nach Figur 2 des im folgenden zu erläuternden Halbleitersystems gewählt, in dem die Schutzstruktur realisiert ist.

In einem Halbleitersubstrat 10 eines ersten Leitungstyps, bei dem es sich vorzugsweise um den p-Leitungstyp handelt, befinden sich erste und zweite Zonen 11, 12 des entgegengesetzten zweiten Leitungstyps, also des n-Leitungstyps. Die dotierten Zonen können beispielsweise durch eine Implantation mit einem anschließenden Temperaturschritt eindiffundiert worden sein. Die zweite Zone 12 ist in diesem Ausführungsbeispiel ein zusammenhängendes Gebiet, welches erfindungsgemäß eine Aussparung 13 im Inneren aufweist, sie kann aber auch aus zwei, durch Teile des Substrats getrennten Bereichen bestehen. Die erste Zone 11 kann, wie in diesem Ausführungsbeispiel, aus mehreren getrennten Bereichen bestehen, die dann vorteilhafterweise auf verschiedenen Seiten der Aussparung 13 liegen.

Zwischen den ersten Zonen 11 und der zweiten Zone 12 können hochdotierte Bereiche 14a des ersten Leitungstyps, sogenannte Channelstopper-Bereiche, angeordnet sein, ebensolche Channelstopper-Bereiche 14b können sich außerhalb der ersten Zonen 11 zur Begrenzung der gesamten Struktur befinden. An der Oberfläche des Halbleitersubstrats 10 sind die ersten und zweiten Zonen 11, 12 durch erste Isolationszonen 15 voneinander isoliert, solche Isolationszonen 15 stellen auch die Isolation zu benachbarten Bauelementen dar. Es handelt sich vorzugsweise um Siliziumoxid-Zonen, die in einem sogenannten LOCOS-Verfahren hergestellt werden können.

Die ersten Zonen 11 können hochdotierte Teilzonen 16 aufweisen, die an die Oberfläche des Halbleitersubstrats 10 heranreichen. Oberhalb der zweiten Zone 12 und ihrer Aussparung 13 befindet sich als dritte Zone eine aufgebrachte epitaktische Schicht 17 des zweiten Leitungstyps, hier also des n-Leitungstyps. Diese dritte Zone 17 berührt also sowohl die zweite Zone 12 als auch aufgrund der Aussparung 13 das Halbleitersubstrat 10.

Über der dritten Zone 17 ist eine vierte Zone 18 des ersten Leitungstyps, also des p-Leitungstyps, angeordnet, die wie die erste und zweite Zone 11, 12 durch Diffusionsprozesse hergestellt worden sein kann. Gemäß dieses Ausführungsbeispiels sind die dritte und vierte Zone 17, 18 seitlich von den ersten Isolationszonen 15 durch weitere hochdotierten Bereiche 19 des ersten Leitungstyps getrennt; diese hochdotierten Bereiche 19, deren Aufgabe noch genauer erläutert wird, können aber auch entfallen.

Auf den ersten Isolationszonen 15 befinden sich zweite Isolationszonen 20, die vorzugsweise durch ganzflächiges Aufbringen einer isolierenden Schicht, beispielsweise Siliziumoxid, und anschließendes strukturiertes Ätzen erzeugt worden sind oder durch Oxidationen bei den Diffusionsprozessen. Die von den ersten und zweiten Isolationszonen 15, 20 nicht bedeckten Teile der Halbleitersubstratoberfläche, also Teile der ersten Zone 11 bzw. ihrer hochdotierten Teilzone 16 und der vierten Zone 18 einschl. eventuell vorhandener hochdotierter Bereiche 19, sind mit Leitbahnen 21, 22 als Anschlüsse versehen. Über die Leitbahn 21 als Eingangsanschluß kann die vierte Zone 18 an den Eingang und über die Leitbahn 22 als Versorgungsanschluß sind die ersten Zonen 11 an das Versorgungspotential 6 angeschlossen werden.

Aufgrund der vorstehend erläuterten Zonenstruktur ergibt sich im Halbleitersystem ein erster pnp-Transistor 3 und ein zweiter npn-Transistor 4. Der erste Transistor 3 wird durch die vierte Zone 18 mit den hochdotierten Bereichen 19 als Emitter, die dritte Zone 17 als Basis und das Malbleitersubstrat 10, insbesondere innerhalb der Aussparung 13, als Kollektor gebildet. Der zweite Transistor 4 wird durch die erste Zone 11 einschl. der hochdotierten Teilzonen 16 als Emitter, das Halbleitersubstrat 10 einschl. der Channelstopperbereiche 14a als Basis und die zweite Zone 12 einschl. der dritten Zone 17 als Kollektor gebildet. Der Emitter 18, 19 des ersten Transistors 3 wird über die Leitbahn 21 mit dem Eingang 1 verbunden, der Emitter 11, 16 des zweiten Transistors 4 wird über die Leitbahn 22 mit dem Versorgungspotential 6 verbunden. Die Basis des einen Transistors ist mit dem Kollektor des anderen Transistors verbunden, und umgekehrt. Insgesamt stellt die Zonenfolge also einen pnpn-Thyristor dar, bestehend aus: vierte Zone 18 einschl. hochdotierte Bereiche 19 - dritte Zone 17 einschl. zweiter Zone 12 - Halbleitersubstrat 10 einschl. Channelstopperbereiche 14a - erste Zone 11 einschl. Teilzone 16.

Der integrierte Widerstand 5 gemäß Figur 1 wird durch das Halbleitersubstrat 10 in Verbindung mit den Channelstopperbereichen 14a gebildet. Er läßt sich durch den Abstand zwischen der ersten Zone 11 und der zweiten Zone 12 sowie durch die eventuell zwischen diesen Zonen vorhandenen Channelstopperbereiche 14a und ihre Dimensionierung variieren. Der integrierte Widerstand 5 wächst mit der Verkleinerung des Abstandes zwischen erster und zweiter Zone; er wird vorteilhaft auf einen Wert in der Größenordnung von 100 Ohm eingestellt. Ein eigener Anschluß des Halbleitersubstrats 10 an das Referenzpotential 2 innerhalb des Gebiets der Eingangsschutzstruktur ist nicht notwendig, es können bereits vorhandene Masseanschlüsse beispielsweise in den zu schützenden Schaltungen verwendet werden.

Als Schutz gegen negative Spannungsimpulse am Eingang 1 kann eine übliche, in den Figuren nicht dargestellte Diode eingesetzt werden, die aus einer mit dem Eingang 1 verbundenen dotierten Zone des zweiten Leitungstyps und dem an das Referenzpotential 2 angeschlossenen Halbleitersubstrat 10 gebildet wird.

Bei positiven Spannungsimpulsen am Eingang 1 arbeitet die Eingangsschutzstruktur als Thyristor. Durch den integrierten Widerstand 5 wird der Kollektorstrom des ersten Transistors 3 in einen Basisstrom des zweiten Transistors 4 und einen Substratstrom aufgeteilt. Das Verhältnis dieser beiden Anteile bestimmt die Haltespannung bzw. den Haltestrom des Thyristors. Der Substratstrom entzieht der Basis 10, 14a des zweiten Transistors 4 den für die Aufrechterhaltung der Thyristorwirkung notwendigen Haltestrom.

Der Ableitung des positiven Impulses steht neben der Thyristor-Strecke noch der direkte Weg über den ersten Transistor 3 zum Masseanschluß 2 des Substrats 10 zur Verfügung, so daß sogar bei Nichtbeschalten des Versorgungsanschlusses 6 eine Schutzfunktion gewährleistet ist. Dieser Fall tritt beim Handling der Bausteine auf, wo keine direkte Versorgung des Anschlusses 6 mit einer Vorspannung gegeben ist. In diesem Fall konkurriert der etwas umständliche Ableitungspfad über den Versorgungsanschluß 6 zum Substrat mit dem direkten Weg über den ersten Transistor 3.

Der erste Transistor 3 wird durch die Weite der Aussparung 13 innerhalb der zweiten Zone 12 (effektive Basisweite) sowie durch die eventuell vorhandenen seitlichen hochdotierten Bereiche 19 (Emitter-Effektivität) dimensioniert.

Die hochdotierten Bereiche 19 dienen also lediglich der Ergiebigkeit des Emitters 18.

Die effektive Basisweite des zweiten Transistors 4 wird durch den Abstand zwischen der ersten 11 und der zweiten Zone 12 und durch die dazwischenliegenden Channelstopperbereiche 14a eingestellt.

Der Vorteil der erfindungsgemäßen Schutzstruktur liegt in der schnellen Ableitung von positiven Spannungsimpulsen am Eingang 1 aufgrund der Thyristorwirkung in Verbindung mit einer hohen Stromtragfähigkeit. Diese Vorteile eines Thyristors werden mit denen der Transistorwirkung des ersten Transistors 3, insbesondere seiner vertikalen Arbeitsweise, kombiniert. Durch den technologischen Aufbau wird der Impuls von der Oberfläche des Halbleiterkristalls fortgeführt. Oberflächendurchbrüche treten nicht auf. Durch die vertikale Arbeitsweise wird eine größere Fläche belastet und dadurch die Schutzwirkung erhöht, da Stellen erhöhter Strombelastung vermieden werden. Die einzelnen Zonen des Thyristors können relativ niedrig dotiert sein, beispielsweise kann der Schichtwiderstand der vierten Zone in der Größenordnung von 100 Ohm/□ , der der dritten Zone einige kΩ/□ betragen. Daher ist die Struktur auch für Hochfrequenzanwendung mit Anforderungen an die maximal zulässige zusätzliche Kapazität geeignet. Der spezielle Aufbau der Schutzstruktur ist an die Bedingungen bei bipolaren integrierten Schaltungen mit einer Oxidisolation zwischen benachbarten Bauelementen angepaßt.

**Ansprüche**

1. Eingangsschutzstruktur für integrierte Schaltungen, welche
- zwischen einen Eingang (1) und einen Anschluß für ein Referenzpotential (2) geschaltet ist,
- in einem Halbleitersubstrat (10) eines ersten Leitungstyps angeordnet ist,
- mindestens einen ersten Transistor (3) und einen zweiten Transistor (4), die durch gegenseitige Kopplung von Basis und Kollektor zu einem Thyristor verschaltet sind, und einen integrierten Widerstand (5) enthält,
**dadurch gekennzeichnet,** daß der integrierte Widerstand (5) zwischen den Kollektor (10, 13) des ersten Transistors (3) und den Anschluß für das Referenzpotential (2) geschaltet ist und der Emitter (11, 16) des zweiten Transistors (4) mit einem Anschluß für ein Versorgungspotential (6) verbunden ist.

2. Eingangsschutzstruktur nach Anspruch 1, **dadurch gekennzeichnet,** daß der Emitter (18, 19) des ersten Transistors (3) mit dem Eingang (1) verbunden ist.

3. Eingangsschutzstruktur nach einem der Ansprüche 1 bis 2, **dadurch gekennzeichnet,** daß der zweite Transistor (4) durch mindestens eine erste Zone (11) des zum ersten entgegengesetzten zweiten Leitungstyps als Emitter, Teile des Halbleitersubstrats (10) als Basis und mindestens eine zweite Zone (12) des zweiten Leitungstyps als Kollektor gebildet wird.

4. Eingangsschutzstruktur nach einem der Ansprüche 1 bis 3, **dadurch gekennzeichnet,** daß der erste Transistor (3) durch das Halbleitersubstrat (10) als Kollektor, mindestens eine dritte Zone (17) des zweiten Leitungstyps als Basis und mindestens eine vierte Zone (18) des ersten Leitungstyps als Emitter gebildet wird.

5. Eingangsschutzstruktur nach Anspruch 3, **dadurch gekennzeichnet,** daß die zweite Zone (12) im Inneren eine Aussparung (13) besitzt.

6. Eingangsschutzstruktur nach einem der Ansprüche 4 bis 5, **dadurch gekennzeichnet,** daß die dritte Zone (17) über der zweiten Zone (12) und der Aussparung (13) und unterhalb der vierten Zone (18) angeordnet ist.

7. Eingangsschutzstruktur nach einem der Ansprüche 1 bis 6, **dadurch gekennzeichnet,** daß der integrierte Widerstand (5) mindestens durch das Halbleitersubstrat (10) gebildet wird.

8. Eingangsschutzstruktur nach einem der Ansprüche 1 bis 7, **dadurch gekennzeichnet,** daß die erste Zone (11) von den übrigen Zonen (12, 17, 18) mindestens durch Isolationszonen (15, 20) an der Oberfläche des Halbleitersubstrats (10) isoliert ist.

9. Eingangsschutzstruktur nach einem der Ansprüche 1 bis 8, **gekennzeichnet** durch hochdotierte Bereiche (14a, 14b) des ersten Leitungstyps innerhalb des Halbleitersubstrats (10) und direkt unterhalb der Isolationszonen (15, 20).

10. Eingangsschutzstruktur nach einem der Ansprüche 1 bis 9, **dadurch gekennzeichnet,** daß die dritte (17) und/oder die vierte (18) Zone durch hochdotierte Bereiche (19) des ersten Leitungstyps seitlich von den Isolationszonen (15, 20) getrennt sind.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | GB-A-2182491 (SGS MICROELETTRONICA)<br>* Seite 1, Zeile 109 – Seite 2, Zeile 5 *<br>* Seite 2, Zeilen 61 – 65; Figuren *<br>--- | 1, 2 | H01L27/02 |
| A | PATENT ABSTRACTS OF JAPAN<br>vol. 8, no. 161 (E-257)(1598) 26 Juli 1984,<br>& JP-A-59 61169 (FUJITSU) 07 April 1984,<br>* das ganze Dokument *<br>----- | 1, 2 | |

RECHERCHIERTE
SACHGEBIETE (Int. Cl.5)

H01L

Der vorliegende Recherchenbericht wurde für alle Patentansprüche erstellt

| Recherchenort | Abschlußdatum der Recherche | Prüfer |
|---|---|---|
| DEN HAAG | 04 MAI 1990 | VENDANGE P. |